# EUROPEAN PATENT SPECIFICATION

(11) **EP 2 240 963 B1**
(45) Date of publication and mention of the grant of the patent: **04.05.2016**
(21) Application number: 08867980.8
(22) Date of filing: 26.12.2008
(51) Int. Cl.: H01L 27/146

(54) **ELECTRICAL ISOLATION OF X-RAY SEMICONDUCTOR IMAGER PIXELS**
ELEKTRISCHE ISOLATION VON PIXELN EINES HALBLEITERRÖNTGENBILDGEBERS
ISOLATION ELECTRIQUE DE PIXELS D'IMAGEUR À RAYONS X À SEMICONDUCTEUR

(30) Priority: 28.12.2007 CN 200710306621
(43) Date of publication of application: 20.10.2010
(73) Proprietor: Koninklijke Philips N.V., 5656 AE Eindhoven (NL); Philips Intellectual Property & Standards GmbH, 20099 Hamburg (DE)
(72) Inventor: ROESSL, Ewald, 22335 Hamburg (DE); PROKSA, Roland, 22335 Hamburg (DE)
(74) Representative: van Velzen, Maaike Mathilde
(86) International application number: PCT/IB2008/055539
(87) International publication number: WO 2009/083920

(56) References cited:
- EP-A- 1 326 278
- WO-A-98/47181
- WO-A-2004/021456
- WO-A-2007/031886
- DE-A1- 3 836 835
- JP-A- 1 172 792
- JP-A- 60 124 879
- US-A- 5 619 033
- US-A1- 2007 085 117

## Description

### Field of the invention

The present invention relates to a semiconductor detector, particularly to a medical semiconductor detector.

### Background of the invention

EP 1 326 278 A2 discloses an image sensor including passivation walls extending above pixel contact pads into a photosensor layer. The passivation walls are located between the pixel contact pads and extend perpendicular to a plane defined by the pixel contact pads for isolating the pixel contact pads to reduce electrical cross-talk, i.e. to reduce a flow of current between adjacent pixel contact pads. In a first embodiment the passivation walls have a rectangular cross section. In another embodiment the passivation walls have a trapezoidal cross section. In both embodiments the passivation walls extend perpendicular to a plane defined by the pixel contact pads.

US 2007/0085117A1 discloses a photodetector array including a semiconductor substrate having first and second main surfaces opposite to each other and having a first layer of a first doping concentration proximate the first main surface and a second layer of a second doping concentration proximate the second main surface. The photodetector includes at least one conductive via and an anode/cathode region proximate the first main surface and the at least one conductive via. The at least one via extends to the second main surface of the semiconductor substrate. The at least one conductive via is isolated from the semiconductor substrate by a first dielectric material. The first anode/cathode layer is of a second conductivity opposite to the first conductivity. The photodetector also includes a doped isolation region formed in the first main surface and extending through the first layer of the semiconductor substrate to at least the second layer of the semiconductor substrate. The isolation region extends perpendicular to a plane defined by the anode/cathode layer.

DE 38 36 835 A1 discloses a photodiode comprising amorphous silicon layers and an upper electrode. The amorphous silicon layers and the upper electrode are formed at positions at which a groove for separating channels is present. An adhesive layer is provided which functions as a protection layer and prevents adjacent photodiodes from short-circuiting through a separator. Each groove reaches a supporting member and also a tip of the separator reaches the supporting member for preventing cross-talk between channels. The grooves and the separators extend perpendicular to a plane defined by, for example, the amorphous silicon layers.

WO 2004/021456 A1 discloses a sensor chip containing several sensor elements arranged in a matrix form. The sensor elements are held by a glass plate. In a wafer layer, the sensor element contains a wafer region which is bonded on the glass plate using an adhesive layer. The wafer region contains silicon and doped regions of a pin diode. An interconnect extends from a connection for the diode to a pad at the edge of the wafer region. An outer interconnect produces an electrically conductive connection between the pad and a solder pellet on a contact area. That side of the wafer region which is remote from the glass plate has a glass plate region which is bonded on the wafer region using an adhesive layer. A part from the solder pellet, the sensor element contains another solder pellet comprising a soft solder on a contact area. There are just two connections for the sensor element, for example, for a ground connection and for a signal connection. Between two sensor elements a groove is present, which has a trapezoidal cross section and which extends perpendicular to a plane defined by contact areas.

US 5,619,033 discloses a photodetection device including a thin-film field effect transistor (TFT). The TFT comprises a metal gate electrode formed on a substrate. The metal comprises refractory metals. A gate dielectric layer of silicon nitride is formed over the gate electrode and the substrate. A layer of hydrogenated amorphous silicon is formed over the gate dielectric layer. An etch stopper is formed over the hydrogenated amorphous silicon layer above the gate electrode. An n+ layer is formed over the hydrogenated amorphous silicon layer and partially over the etch stopper layer. A TiW metal layer is formed over the n+ layer and an A1 layer is formed over the TiW layer.
The TiW layer serves as a barrier layer preventing the A1 layer from interacting with the n+ layer. The n+ layer, the TiW metal layer and the A1 layer on the left side of the etch stopper form the source electrode of the TFT, and the n+ layer, the TiW metal layer and the A1 layer on the right side of the etch stopper form the drain electrode of the TFT. A silicon oxynitride layer is formed over the TFT having a via hole. An n+ doped layer is formed over the silicon oxynitride layer making contact with the drain electrode. An undoped amorphous silicon layer is formed over the n+ doped layer. A p+ doped layer is formed over the undoped hydrogenated amorphous silicon layer, and a conductive layer is formed over the p+ doped layer. A SiON layer is formed over the conductive layer having a via hole. A bias contact is formed over the SiON and contacts the conductive layer. A passivation layer is formed over both the conductive layer and the bias contact.

WO 2007/031886 A2 discloses a detector including metal electrodes located on either side of a direct conversion material to form an anode side and a cathode side. The electrodes on the anode side are separated by a gap of oxidized material. The gap forms a trench that elongates a path I_{B} an electron must take in order to move from a first electrode to an adjacent second electrode.
The trench is used for reducing surface leakage. The trench extends perpendicular to a plane defined by an opening between two adjacent electrodes.

WO 98/47181 discloses a TFA sensor comprising several pixels. Each pixel comprises several detection layers, wherein detection layers of adjacent pixels are separated by an isolation layer.
The isolation layer extends perpendicular to a plane in which contacts are located.

JP 60124879 A discloses a substrate having isolation grooves arranged at regular intervals formed at a surface of the substrate. Thin-film electrodes are attached and shaped on the surfaces between two adjacent isolation grooves. These separate thin-film electrodes form Schottky-barrier junctions among the thin-film electrodes and the substrate, and function as sensing electrodes. Common electrodes are formed on other surfaces of the substrate being opposite to the thin-film electrodes. The grooves comprise a wider region adjacent to the thin-film electrodes and a thinner region adjacent to the common electrodes. The isolation grooves extend perpendicular to a plane defined by the thin-film electrodes.

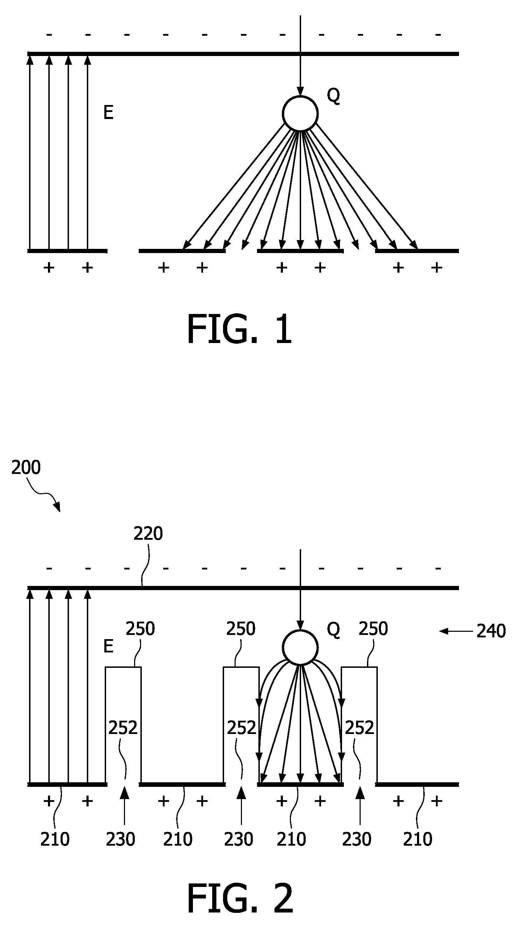

In medical industry, direct conversion materials, such as Si, GaAs, CdTe, and CZT gain more and more importance in modalities, such as CT detectors, X-ray detectors, Gamma detectors, and nuclear medicine in which the scintillator type detectors are still state of the art. Their advantage over scintillators is the possibility of photon-counting coupled with a good energy solution. However, these direct conversion materials are vulnerable because of charge sharing, a phenomenon in which the charge cloud generated by a single photon is collected by several neighboring electrodes. Fig. 1 shows that a charge cloud generated by one photon is collected by three neighboring electrodes. The phenomenon of charge sharing disturbs the spectral resolution and count rate performance of detectors. In high-rate detectors, the phenomenon of charge sharing limits the effort of adopting smaller pixels. At the same time, the phenomenon of K-escape also limits the adoption of smaller pixel sizes. K-escape is primarily caused by partial transport of the primary energy, e.g. X-ray energy, through another quantum, e.g. an X-ray quantum, to a neighboring pixel.

Thus there is a need to solve or mitigate the negative influence of charge sharing, especially in detectors based on direct conversion materials.

### Summary of the invention

It is an object of the present invention to provide an improved semiconductor detector.

In one embodiment, it is advantageous to mitigate the negative effect caused by charge sharing and thereby improve the spectral resolution and count rate performance of semiconductor detectors.

In one embodiment, it is advantageous to mitigate, or even eliminate the K-escape phenomenon of semiconductor detectors and thereby improve the count rate performance of semiconductor detectors.

In one embodiment, it is advantageous to mitigate the negative effect of charge sharing and K-escape on the miniaturization of pixel sizes of semiconductor detectors.

In a first aspect, according to one embodiment of the invention, a semiconductor detector is provided, comprising: a plurality of anodes arranged to form at least one opening, each opening being formed by two adjacent anodes in the plurality of anodes; at least one cathode; a detector cell located between the plurality of anodes and the at least one cathode; wherein the detector cell comprises at least one groove, each of the at least one groove having a first opening aligned with one of the at least one opening being formed by two adjacent anodes in the plurality of anodes, each of the at least one groove extending towards the at least one cathode, wherein each of the at least one groove extends along a direction of extension not perpendicular to the plane of its first opening. Forming one or more grooves in the detector cell is efficient to guide the charge cloud generated by a single photon received by a corresponding anode, instead of being received by several neighboring anodes. This provides the advantage of mitigating the negative effect of charge sharing on spectral resolution and count rate performance.

Each groove extends along a direction away from a direction which is perpendicular to the plane of its first opening. In other words, the direction of extension of the groove is inclined instead of being perpendicular to the tangential plane of a corresponding opening formed by two corresponding adjacent anodes. This shape is advantageous in that it decreases the phenomenon of reducing DQE (Detector Quantum Efficiency) of detectors.

In a second aspect, according to one embodiment of the invention, each groove comprises an insulator which is helpful in mitigating, or even eliminating, the negative effect of the K-escape phenomenon. It is preferred to use insulator with a high atomic number Z.

These and other aspects, features and/or advantages of the invention are apparent from and will be elucidated with reference to the embodiments described hereinafter.

### Brief description of the drawings

Fig. 1 illustrates the phenomenon of charge sharing;
Fig. 2 illustrates a semiconductor detector comprising grooves perpendicular to the surface of a plurality of anodes, according to an example not forming part of the claimed invention;
Fig. 3 illustrates a semiconductor detector comprising grooves extending along a tilt angle away from the perpendicular direction of a plurality of anodes, according to one embodiment of the invention;
Fig. 4 illustrates a semiconductor detector comprising grooves filled by insulators, according to one embodiment of the invention.

### Description of embodiments

An example of a structured semiconductor detector which mitigates or overcomes the drawback of the charge sharing effect in current semiconductor detectors is shown in Fig. 2. The detector 200 comprises a plurality of anodes 210, at least one cathode 220, and a detector cell 240. The anodes and the at least one cathode can be arranged in parallel, or in another configuration. Every two adjacent anodes form an opening 230. From each opening, a groove 250 extends into the detector cell 240, with its direction perpendicular to the plane of the opening 230. Each groove 250 has a first opening 252, which may have the same width as the corresponding opening 230, or which may be larger/smaller than the corresponding opening 230. It can clearly be seen that, due to the existence of grooves, a charge cloud generated by a photon is received by one corresponding anode instead of by two or more adjacent anodes.

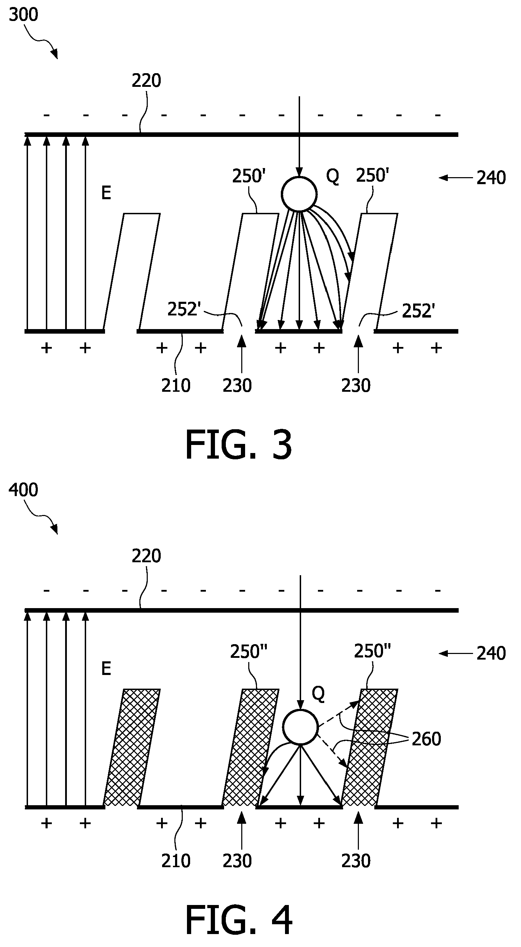

An embodiment is shown in Fig. 3, in which the direction of extension of the grooves is not perpendicular to the plane of the opening 230, i.e. the plane of the first opening 252' of each groove. Each groove 250', or at least part of the grooves, extends along a tilt direction which is not perpendicular to the opening 230, i.e. its first opening 252'. The drawback of a reduced DQE (Detector Quantum Efficiency) caused by a reduced stopping power can be mitigated with the tilt direction. The angle of the extending direction of the grooves 250' may vary in dependence on some factors, including mechanical stability, stopping power, density and thickness of the sensor material, and also the X-ray spectrum used. The skilled person can adapt the angle of the extending direction to the real situation. Optionally, the thickness of the detector cell 240, e.g. the crystal used, can be slightly increased.

In the example of Fig. 2 and the embodiment of Fig. 3, the depth of grooves may vary in dependence on demands and/or manufacturing techniques. The grooves may extend slightly into the detector cell 240, halfway into the detector cell 240, or even extend from the opening 230 to the plane of the cathode. In the latter case, the groove has a second opening located at the surface of the cathode.

The example shown in Fig. 2 and the embodiment shown in Fig. 3 can be combined in any configuration. For example, it is allowed to combine part of the grooves extending along a direction perpendicular to the plane of their first opening 252 and part of the grooves extending along tilt directions away from the perpendicular direction of the plane of their first opening 252, respectively. Especially for the part of the detector cell which is rather blind to the incoming photons, e.g. X-ray photons, the grooves extend along the perpendicular direction. For the other part of the detector cell, the grooves extend along tilt directions, which is advantageous for improving the DQE.

K-escape is caused by a photo-effect releasing a K-shell electron from an atom in the detector cell, with the K-shell being refilled almost instantly from a higher shell electron and thereby releasing a characteristic amount of energy in the form of a K-escape photon. This photon can be transported from one place to another in the detector cell and may give rise to another signal elsewhere in the detector. Fig. 4 illustrates an embodiment according to the present invention, which mitigates/eliminates the K-escape phenomenon. Each groove 250" is filled with an insulator which can effectively stop this migrating energy, i.e. K-escape photons, denoted by reference numeral 260, and can thus suppress or even prevent the production of disturbing signals. Optionally, the insulator is made of an insulating material with a high atomic number Z.

The example and embodiments of the semiconductor detector shown in Figs. 2 to 4 can be used in medical equipment, at least including CT scanners, X-ray detectors and Gamma-ray detectors.

The example and embodiments shown in Figs. 2 to 4 can be combined in any configuration. Although the present invention has been described with reference to the specified embodiments, it is not intended to be limited to the specific form set forth herein. Rather, the scope of the present invention is limited only by the accompanying claims. In the claims, use of the verb "comprise" and its conjugations does not exclude the presence of other elements or steps.

## Claims

1. A semiconductor detector (300; 400) comprising:
- a plurality of anodes (210) arranged to form at least one opening (230), each opening (230) being formed by two adjacent anodes in the plurality of anodes (210);
- at least one cathode (220);
- a detector cell (240) located between the plurality of anodes (210) and the at least one cathode (220);
wherein the detector cell (240) is made from a crystal and comprises at least one groove (250'; 250"), each of the at least one groove (250'; 250") having a first opening aligned with one of the at least one opening (230) being formed by two adjacent anodes in the plurality of anodes (210), each of the at least one groove (250'; 250") extending from the one of the at least one opening towards the at least one cathode (220), **characterized in that** each of the at least one groove (250'; 250") extends along a direction of extension not perpendicular to the plane of its first opening.

2. The semiconductor detector (300; 400) according to claim 1, wherein each of the at least one groove (250'; 250") has a second opening located at a surface of the at least one cathode (220).

3. The semiconductor detector (300; 400) according to claim 1, wherein each of the at least one groove (250") comprises an insulator.

4. The semiconductor detector (300; 400) according to claim 1, wherein the detector cell (240) is made of a direct conversion material.

5. The semiconductor detector (300; 400) according to claim 1, further configured to detect x-ray quanta.

6. A medical scanner comprising a semiconductor detector (300; 400) according to claim 1.

7. The medical scanner according to claim 6, being any one of a CT scanner, an X-ray detector, and a Gamma-ray detector.

## Patentansprüche

1. Halbleiterdetektor (300; 400), der Folgendes umfasst:
- eine Vielzahl von Anoden (210), die angeordnet sind, um mindestens eine Öffnung (230) zu bilden, wobei jede Öffnung (230) durch zwei benachbarte Anoden in der Vielzahl von Anoden (210) gebildet wird;
- mindestens eine Kathode (220);
- eine Detektorzelle (240), die zwischen der Vielzahl von Anoden (210) und der mindestens einen Kathode (220) positioniert ist;
wobei die Detektorzelle (240) aus einem Kristall besteht und mindestens eine Rille (250', 250") umfasst, wobei jeder der mindestens einen Rille (250'; 250") eine erste Öffnung hat, die mit einer der mindestens einen Öffnung (230), welche durch zwei benachbarte Anoden in der Vielzahl von Anoden (210) gebildet wird, ausgerichtet ist, wobei jede der mindestens einen Rille (250'; 250") von der einen der mindestens einen Öffnung zu der mindestens einen Kathode (220) verläuft, **dadurch gekennzeichnet, dass** jede der mindestens einen Rille (250'; 250") entlang einer Erstreckungsrichtung verläuft, die sich nicht senkrecht zu der Ebene ihrer ersten Öffnung erstreckt.

2. Halbleiterdetektor (300; 400) nach Anspruch 1, wobei jede der mindestens einen Rille (250'; 250") eine zweite Öffnung hat, die sich an einer Oberfläche der mindestens einen Kathode (220) befindet.

3. Halbleiterdetektor (300; 400) nach Anspruch 1, wobei jede der mindestens einen Rille (250") einen Isolator umfasst.

4. Halbleiterdetektor (300; 400) nach Anspruch 1, wobei die Detektorzelle (240) aus einem Direktumwandlungsmaterial besteht.

5. Halbleiterdetektor (300; 400) nach Anspruch 1, weiterhin konfiguriert, um Röntgenquanten zu detektieren.

6. Medizinischer Scanner mit einem Halbleiterdetektor (300; 400) nach Anspruch 1.

7. Medizinischer Scanner nach Anspruch 6, wobei es sich entweder um einen CT-Scanner, einen Röntgendetektor oder einen Gammastrahlendetektor handelt.

## Revendications

1. Détecteur (300 ; 400) à semi-conducteurs comprenant :
- une pluralité d'anodes (210) agencées pour former au moins une ouverture (230), chaque ouverture (230) étant formée par deux anodes adjacentes de la pluralité d'anodes (210) ;
- au moins une cathode (220) ;
- une cellule de détection (240) située entre la pluralité d'anodes (210) et l'au moins une cathode (220) ;
dans lequel la cellule de détection (240) est constituée d'un cristal et comprend au moins une rainure (250' ; 250"), chacune de l'au moins une rainure (250' ; 250") ayant une première ouverture alignée sur une de l'au moins une ouverture (230) formée par deux anodes adjacentes de la pluralité d'anodes (210), chacune de l'au moins une rainure (250' ; 250") s'étendant depuis l'une de l'au moins une ouverture vers l'au moins une cathode (220), **caractérisé en ce que** chacune de l'au moins une rainure (250' ; 250") s'étend le long d'une direction d'extension non perpendiculaire au plan de sa première ouverture.

2. Détecteur (300 ; 400) à semi-conducteurs selon la revendication 1, dans lequel chacune de l'au moins une rainure (250' ; 250") a une deuxième ouverture située au niveau d'une surface de l'au moins une cathode (220).

3. Détecteur (300 ; 400) à semi-conducteurs selon la revendication 1, dans lequel chacune de l'au moins une rainure (250') comprend un isolant.

4. Détecteur (300 ; 400) à semi-conducteurs selon la revendication 1, dans lequel la cellule détectrice (240) est constituée d'un matériau à conversion directe.

5. Détecteur (300 ; 400) à semi-conducteurs selon la revendication 1, configuré en outre pour détecter des quanta de rayons x.

6. Scanner médical comprenant un détecteur (300 ; 400) à semi-conducteurs selon la revendication 1.

7. Scanner médical selon la revendication 6, qui est l'un quelconque parmi un scanner CT, un détecteur à rayons X et un détecteur à rayons Gamma
